(19) Europäisches Patentamt
European Patent Office
Office européen des brevets

(11) **EP 1 813 022 B1**

(12) **EUROPEAN PATENT SPECIFICATION**

(45) Date of publication and mention
of the grant of the patent:
**27.07.2011 Bulletin 2011/30**

(51) Int Cl.:
***H03M 7/30*** (2006.01)    ***G06T 9/00*** (2006.01)

(21) Application number: **04822654.2**

(86) International application number:
**PCT/EP2004/013109**

(22) Date of filing: **18.11.2004**

(87) International publication number:
**WO 2006/053582 (26.05.2006 Gazette 2006/21)**

(54) **LOSSLESS COMPRESSION OF DATA, IN PARTICULAR GRIB1 FILES**

VERLUSTLOSE KOMPRIMIERUNG VON DATEN INSBESONDERE VON GRIB1-DATEIEN

COMPRESSION SANS PERTE DE DONNEES, EN PARTICULIER DE FICHIERS GRIB1

(84) Designated Contracting States:
**DE FR GB**

(43) Date of publication of application:
**01.08.2007 Bulletin 2007/31**

(73) Proprietor: **Fraunhofer-Gesellschaft zur Förderung der angewandten Forschung e.V.
80686 München (DE)**

(72) Inventors:
• **LORENTZ, Rudolph
53757 Sankt Augustin (DE)**
• **IZA-TERAN, Rodrigo
53757 Sankt Augustin (DE)**

(74) Representative: **von Kreisler Selting Werner
Deichmannhaus am Dom
Bahnhofsvorplatz 1
50667 Köln (DE)**

(56) References cited:
• **AIAZZI B ET AL: "Reversible compression of multispectral imagery based on an enhanced inter-band JPEG prediction" GEOSCIENCE AND REMOTE SENSING, 1997. IGARSS '97. REMOTE SENSING - A SCIENTIFIC VISION FOR SUSTAINABLE DEVELOPMENT., 1997 IEEE INTERNATIONAL SINGAPORE 3-8 AUG. 1997, NEW YORK, NY, USA,IEEE, US, vol. 4, 3 August 1997 (1997-08-03), pages 1990-1992, XP010234648 ISBN: 0-7803-3836-7**
• **JUNGWOO LEE ED - INSTITUTE OF ELECTRICAL AND ELECTRONICS ENGINEERS: "Least squares approach for predictive coding of 3-D images" PROCEEDINGS OF THE INTERNATIONAL CONFERENCE ON IMAGE PROCESSING (ICIP) LAUSANNE, SEPT. 16 - 19, 1996, NEW YORK, IEEE, US, vol. VOL. 1, 16 September 1996 (1996-09-16), pages 875-878, XP010202797 ISBN: 0-7803-3259-8**
• **LEE H S ET AL: "Hyperspectral image cube compression combining JPEG-2000 and spectral decorrelation" PROCEEDINGS OF IEEE INTERNATIONAL GEOSCIENCE AND REMOTE SENSING SYMPOSIUM. IGARSS 2002, vol. 6, 24 June 2002 (2002-06-24), pages 3317-3319, XP010599220**
• **LUCERO A ET AL: "Compressing three-dimensional GRIB meteorological data using KLT and JPEG 2000" IGARSS 2003. IEEE 2003 INTERNATIONAL GEOSCIENCE AND REMOTE SENSING SYMPOSIUM. PROCEEDINGS. TOULOUSE, FRANCE, JULY 21 - 25, 2003, IEEE INTERNATIONAL GEOSCIENCE AND REMOTE SENSING SYMPOSIUM, NEW YORK, NY : IEEE, US, vol. VOL 7 OF 7, 21 July 2003 (2003-07-21), pages 1836-1838, XP010703822 ISBN: 0-7803-7929-2**
• **CHRISTOPHER E. STEFFEN, NING WANG: "Weather Data Compression" 19TH INTERNATIONAL CONFERENCE ON INTERACTIVE INFORMATION PROCESSING SYSTEMS, 9 February 2003 (2003-02-09), pages 1-6, XP002313892 cited in the application**

EP 1 813 022 B1

- IBARRIA L ET AL: "Out-of-core compression and decompression of large n-dimensional scalar fields" COMPUTER GRAPHICS FORUM BLACKWELL PUBLISHERS FOR EUROGRAPHICS ASSOC UK, vol. 22, no. 3, 1 September 2003 (2003-09-01), pages 343-348, XP002313893 ISSN: 0167-7055 cited in the application
- SAUPE D. HARTENSTEIN H. WERGEN W.: "Compression of weather forecast data" 12TH INT. CONF. ON INTERACTIVE PROCESSING SYSTEMS FOR METEOROLOGY, OCEANOGRAPH AND HYDROLOGY, January 1996 (1996-01), pages 1-4, XP002313894 ATLANTA cited in the application
- USEVITCH B.E.: 'JPEG2000 extensions for bit plane coding of floating point data' DATA COMPRESSION CONFERENCE, PROCEEDINGS. DCC, IEEE COMPUTER SOCIETY PRESS, LOS ALAMITOS, CA, US 25 March 2003, page 451, XP002402963
- USEVITCH B E: "JPEG2000 extensions for bit plane coding of floating point data" DATA COMPRESSION CONFERENCE, PROCEEDINGS. DCC, IEEE COMPUTER SOCIETY PRESS, LOS ALAMITOS, CA, US, 25 March 2003 (2003-03-25), page 451, XP002402963

**Description**

**Technical field**

The invention is a method for lossless and fast compression of three-dimensional (abreviated by 3D in the following) floating point data stored as a file in a computer. Basically the format of the data to be compressed is arbitrary as long as the 3D floating point data are represented by several layers of two-dimensional (abbreviated as 2D in the following) of integer data wherein each layer has its individual integer scaling factor. However, the invention in particular is applicable to the compression of data stored in the GRIB 1 format for gridded data in binary form. Nevertheless, in the following reference is made to GRIB 1-formated data in order to explain the prior art and the invention.

1) Compression means that the data requires less storage capacity in the computer after the invention has been applied.
2) Lossless means that the original data can be recovered exactly from the compressed data.
3) The GRIB1 format is an international standard for exchange and archiving of meteorological data: "FM 92-IX Ext. - GRIB" (gridded binary), World Meteorological Organization (WMO) Manual on Codes, Publication 306, Volume 1, Part B, 1988 Edition, Supplement No. 3 (VIII.1991).

The GRIB-1 format takes a two-dimensional field of floating point numbers and stores it as a block of positive binary numbers together with a reference value and two scaling factors.
In addition there is a header with META data concerning the type and origin of the data stored. This is called a GRIB file. The GRIB1 format allows the specification of the bit length and the precision of the stored data by means of parameters. (See the section "The GRIB format") The invention compresses such files without loss. This is in contrast to lossy methods of compression as, for example, MPEG.
The intended application of the invention is the rapid and lossless compression of all of the GRIB data, which is generated daily in a meteorological institute or weather service.
The advantages of such a compression are

1) Less storage capacity required. This is important since the capacity required may run into the petabyte region.
2) Faster transmission of data either to external customers or within the institution.

**State of the art**

Two research groups have investigated the compression of meteorological data in connection with the GRIB format. The first group: N. Wang, R. Brummer and C. Steffen of the NOAA (National Oceanic and Atmospheric Administration) - used lossy two dimensional (2D) wavelet methods. The lost data was stored in an additional "difference" file. They also tried the method of 2D differences followed by arithmetic encoding, but rejected it.
The second group: H. Hartenstein and D. Saupe of the University of Freiburg together with W. Wergen from the Deutscher Wetterdienst (German Weather Service) used an unspecified 2D linear prediction method followed by arithmetic encoding of the prediction error.
Both take the original meteorological data as their starting point and recommend a reduction of the data precision. In other words, they stipulate the parameters of the GRIB format.
However, each meteorological institute has its own set of tested parameters and is not prepared to change them. The Deutscher Wetterdienst, for example, prescribes the bit length to be 16 and the decimal scaling to be 0.
Nevertheless, one can investigate whether the methods proposed by these groups are applicable to the task at hand.
There are many methods for the lossless general numerical data, that is, for data which are not in GRIB format. The best known are JPEG2000 (in the lossless mode) and JPEG-LS. Both of these are intended for 2D integer data and use integer arithmetic.
JPEG2000 (ISO/IEC 15444-1, 2000, JPEG2000 Image Coding System) has a lossless mode which yields good compression factors for pictures. It is wavelet based.
JPEG-LS (ISO/IEC JTC1/SC29/WG1, FDIS14495-1) is also intended for the compression of pictures. This means that the input is a rectangular array of integers. It is based on a linear prediction method, yields good compression factors and is extremely fast. As a linear method, is best suited for data with medium to low smoothness.
An additional method proposed is the method of differences, 2D, 3D or higher differences, followed by some entropy encoder. The NOAA group tried a 2D version, which they called Paeth filter. The method of differences for the compression of data of arbitrarily high special dimension was tested by Ibarra, Lindstrom, Rossignac, and Szymczak under the name "Lorenzo predictor". Both groups used arithmetic encoding of the prediction errors.

**Deficiencies of the State of the Art**

The conclusions which will be reached below can be abbreviated as follows. If one were to apply the methods suggested above to the job at hand, that is to the lossless compression of existing GRIB files, then

A) their compression factors would be too small or
B) they would be too slow.

As mentioned above, no one has treated the problem of compressing existing GRIB files.

The quality of a compression technique depends on

1) the compression factor and
2) the execution speed.

The compression factor is the factor by which the size of the uncompressed file is larger than the size of the compressed file, that is, it should be larger than 1.

We must distinguish between 2D data and 3D data. 2D data is data which is given on a two dimensional grid. In our case, these would be the values of some meteorological variable as measured or calculated on a rectangular 2D grid. Such a set of values is put into one GRIB file. By 3D data we mean a collection of 2D data fields which all are values of one and the same meteorological variable on the same rectangular grid but at different heights. An example for this is temperature. Temperature is measured or calculated on a rectangular grid on the surface of the earth as well as at various heights above the surface. The values at each of these heights is a 2D field of values which would be put into a separate GRIB file.

The following can be said in general about wavelet compression methods.

1) They are too slow: they are about 3-4 times slower than the invention.
2) They have good compression factors and can, in principle, be adapted to the smoothness of the data.
3) 3D-wavelets cannot take advantage of the correlation existing in 3D GRIB data to achieve better compression rates.
4) Most 3D wavelet compression methods use floating point arithmetic at some point and therefore cannot be guaranteed to be computer independent.

The following can be said in general about linear extrapolation methods (this includes differencing methods).

1) One can form the differences extremely fast, but the entropy encoding methods, either Huffmann or arithmetic encoding, used for the prediction errors are too slow.
2) They usually use integer arithmetic and are therefore computer independent.
3) They cannot be adapted to the smoothness of the data.
4) They cannot take advantage the of the correlation existing in 3D GRIB data to achieve better compression rates.

The NOAA group uses lossy 2D wavelet methods. The error due to the lossy method is calculated and compressed with some entropy encoding. Although the number of values in the error file is as large as in the original data file, it can be very well compressed since the errors are small integer numbers. The disadvantages of this approach are

1) it is based on wavelets and is therefore too slow
2) it can takes advantage only of 2D correlation and not of the 3D correlation inherent in 3D GRIB data sets.
3) The results are computer dependent, since floating point arithmetic is used.

The group Saupe et al uses a linear 2D prediction method followed by arithmetic encoding of the errors. It is difficult to make concrete conclusions about their approach, since the details are not revealed. Nevertheless the method is

1) 2D and has the deficiencies explained under 2) above.
2) Linear and therefore does not adapt itself to the smoothness of the data.
3) Whether their method is computer dependent is not clear

In AIAZZI B ET AL:"Reversible compression of multispectral imagery based on an enhanced inter-band JPEG prediction" GEOSCIENCE AND REMOTE SENSING, 1997. IGARSS '97, vol, 4, 3, pages 1990-1992 a modified inter-band scheme based on the predictors used by lossless JPEG is proposed for Lossless data compression of multispectral images. In this known method the value of the current pixel in the current band is predicted by the best JPEG predictor on the previously encoded band. Improvements are achieved by considering wherein also the corresponding prediction error on the previous band is considerable.

In JUNGWOO LEE: "Least squares approach for predictive coding of 3-D images" PROCEEDINGS OF THE INTERNATIONAL CONFERENCE ON IMAGE PROCESSING (ICIP) LAUSANNE, vol. 1, pages 875-878 a new compression technique using luminance compensation with adaptive block size for multispectral or volumetric images is proposed. The luminance compensation which is a function approximation technique is updated block by block for efficient coding. The luminance compensation based on least squares takes advantage of the relationship of almost identical spatial feature. A Lagrange multiplier technique is also used to optimize the quadtree for the adaptive block size. In this reference, three dimensional images are regarded that have similar spatial features between neighboring 2-D slice images (bands). For example, multispectral images and medical volumetric image roughly have such characteristics.

**The Problem Solved by the Invention**

The invention compresses files of 3D fields of floating points data (in particular GRIB-type files for compression purposes so that they require less storage capacity on a computer. The invention can also decompress the files in which case the decompressed files are identical with the original files (lossless compression). The invention can be used in either manual or the automatic mode to

1) take advantage of all the smoothness of the data to obtain better compression factors

2) take advantage of the 3D correlation of 3D GRIB data to obtain better compression factors

3) at a speed which is equal to the fastest lossless 2d compression tools (at the moment this is JPEG-LS).

It is to be assumed that

1) the invention yields better compression factors at faster execution speeds than any other lossless compression method for GRIB files know today, and
2) the files compressed on one computer can be decompressed without loss on any other computer: the method is computer independent.

The first assumption is based on the results of compressing the GRIB files resulting from a typical weather forecast. This is a suite of approximately 370 GRIB files having a total size of about 320 MB (Megabyte).

This assumption is not meant in the mathematical sense in that it can be mathematically proved. It is the conclusion made after many test runs. It is possible that the assumption about the compression factors do not hold for some extreme weather conditions.

**Summary of the Invention**

The invention is a method for compressing 3D floating point data, in particular 3D meteorological data, represented by several layers of 2D Integer data each layer having its individual integer scaling factor, as defined in claim 1 and claim 2, respectively.

The major goal of data compression is to reduce storage space for the data. This can be achieved by describing the data sets by means of the differences between the individual data. As long as the data to be compressed does vary merely little, storing the difference values between the data requires less storage space than storing the data as such. However, in some applications such as in files of meteorological data, the values presented by the data can vary significantly. This is for example true for meteorological specific humidity or pressure data which both can vary significantly depending on the height over ground.

One of the key aspects of the invention is that determining the differences between adjacent 2D data layers of a 3D data set makes it possible to describe the data with a small amount of digits only (assuming that scaling factors and standarization is taken into consideration so as to make the 2D data layers comparable to each other). Namely, even if throughout all of the 2D data layers of a 3D data set the data values in Z-direction could significantly vary, the data from layer to layer does not. Accordingly, preprocessing the 3D data with respect to the determination of differences between adjacent data as mentioned above results in a data format using merely little space. This data format furthermore can be used to compress the 3D data set using well know 2D data processing methods such as JPEG LS or JPEG 2000 for example.

In contrast, existing 3D-wavelet methods would take differences of values from the bottom layer and the top layer. These differences could be numbers with more digits than the original data, nullifying any compression gain.

**Basic Ideas**

**Introduction**

The basic ideas of the method will be described in this part. Details can be found in the appendix. First the building blocks will be described, then the whole procedure. The method consists of two parts. They are

1) the compression,
2) the decompression.

The compression consists of four parts, namely

1) the extraction,
2) the preprocessing,
3) the application of JPEG-LS,
4) the assemblage of the compressed file.

It will be assumed in the following that the positive integers contained in the GRIB files together with their scaling factors have been extracted. Note that these are not the function variables. For the connection, see the section "The GRIB Format".
The numbers will be processed exclusively in integer arithmetic.
The preprocessing is based on differences of various orders. For 2D fields, differences are used in the standard way. For 3D fields, they must be modified. For 2D fields, preprocessing with differences effectively increases the extrapolation order of JPEG-LS. For example, applying differences once increases the extrapolation order of JPEG-LS from linear to quadratic. Applying 3D differences to 3D data results in both increasing the extrapolation order of JPEG-LS and in exploiting the 3D correlation for better compression factors.

What is new is

1) Using 2D differences in combination with JPEG-LS (or another 2D compression method) to increase the compression factor for smooth data.
2) The modification of 3D differences to suit the special form of the GRIB format to

a) To exploit the 3D correlation of the data
b) To exploit all the smoothness of the data to increase the compression factor.

The preprocessing involving differences can be carried out so fast that its contribution to the total computational cost is negligible.
The process of forming differences, both 2D differences as well as 3D differences, has three properties

a) Forming differences does not change the number of data.
b) The original field of data can be recovered exactly from the processed field.
c) If the original field of data are the values of a smooth physical variable, then the differences are smaller than the original numbers and can be better compressed: the smoother the variable, the smaller the differences.

**Application of 2D differences to 2D data**

As before, it will be assumed that the field of integers has been extracted from the GRIB file.
2D differences will be taken either not at all, one time or two times. Which of the cases obtains will be explained later.

0) In differences are not to be taken, the 2D field of integers is passed on unchanged to JPEG-LS to be compressed.
1) If 2D differences are applied once, a new field of differences (which may also contain negative numbers) is obtained. The first value of this stored separately, its value in the field is set to zero, the field is transformed to positive integers by subtracting the smallest value in it form the other values in it and the resulting field is passed to JPEG-LS to be compressed.

2) If 2D differences are applied twice, one first proceeds as in 1) above to when the first value is stored. 2D differences are then again applied to this field. The first row and column of the resulting field are stored separately. Then the field is transformed to positive integers by subtracting the smallest value in it form the other values in it. Finally it is passed to JPEG-LS to be compressed.

## Application of 3D differences to 3D data

It will be assumed that a sequence of integer GRIB data has been extracted and assembled to a 3D field as explained above.

3D differences will be applied either not at all or one time. Which of the cases obtains will be explained later.

1) If 3D differences are not to be applied, then the 2D fields are separated again and each is processed as an independent 2D field as explained above for 2D data fields.

2) If 3D differences are to be applied, then first 2D differences are applied to each of the 2D fields. Then differences in the third dimension (upwards) are applied according to the formula given in the appendix. The first row and first column are removed from the lowest row and column and stored separately. Their positions in the field are replaced by zeros. Then one continues as at the end of 2) for 2D fields above. The higher 2D fields are each treated as in 1) for 2D fields after differences are taken.

## Determination of the Number of Differences

Practice has shown that the compression properties of the values found in GRIB files does depend on the physical variable itself but does not change much over time. Thus one can use one instance of the values to determine the optimal number of differences to be applied and can be fairly confident that this choice is reasonable for any other instance of the values.

As an example, we can take the test data from the German Weather Service. The data contains seven 3D variables as well as many 2D variables. It was determined that 3D differences yield good compression factors for five of them and that the other two should be preprocessed with 2D differences. Having determined this once, one can "hard wire" this into the method.

## Separately Stored Data

In the compression phase certain data is extracted from the data fields to be stored separately. For example, for 2D differences the first value does not take part in any differencing. It is therefore much larger than the other values in the field. If this value were not stored separately, the whole field would require a larger bit length of storage and would not be compressed as well by JPEG-LS.

## The Complete Method

A compressed file contains two headers and the compressed data. The first header, header1, consists of

1) for 2D data: the GRIB header

2) for 3D data: the GRIB headers of all the GRIB files which have been assembled to form the 3D field.

These headers are copied directly from the GRIB files. They are not compressed.

The second header, header2, contains the information needed to reconstruct the original data. It includes the separately stored data and the minimum values of the 2D fields. Header2 also contains other bookkeeping information which will not be discussed. Just as one example, one needs to know where header2 ends and where the compressed data starts.

The only difference between a previously fixed number of differences and the dynamic mode consists in that, in the dynamic mode, one keeps taking differences until a given stopping criterion has been met. For this reason, only the manual mode will be described.

First the GRIB data is extracted and the 3D fields are assembled.

1) The method for 2D data: the GRIB header is written as header1. Then 0), 1) and 2) as described above for 2D data are carried out in dependence of the number of differences to be taken. For 0), the compressed data are written to the compressed file. For 1), the first value and the minimum value of the field of the field obtained after taking differences are written to header2. Then the compressed data is written to the file. For 2), the first row and the first column and the minimum value of the field of the field obtained after taking differences twice are written to header2. Then the compressed data is written to the file.

2) The method for 3D data: All GRIB headers are written to header1. Then 1) and 2) as described above for 3D data are carried out in dependence of the number of differences to be taken. For 1), the data is compressed by JPEG-LS and then written to the file. For 2), the first row and the first column of the lowest level are written to header2. The first values of the other layers as well as all the field minima are the written to header2 and then all of the compressed 2D fields are written one after the other to the compressed file.

**The Decompression**

The first step of the decompression is just applying JPEG-LS decompression to all of the 2D fields involved. Then the minimum values of all of the 2D fields are added back. These minimum values are in header2.

The principle of the decompression of the differences can be explained most easily in the one dimensional case. Then the uncompressed data is a sequence of positive integers $F_i$ for $i$=1, ..., M. The differences for this field are $G_i = F_i - F_{i-1}$ for i = 2,...,M. For the decompression, these differences as well as the first value $F_1$ of the field are available. From $F_1$ and $G_2 = F_2 - F_1$, we obtain $F_2$. From $F_2$ and $G_3 = F_3 - F_2$, we obtain $F_3$ and so on.

2D differences are formed by first applying 1D differences to the rows, then 1D differences to the columns. 2D decompression is then 1D decompression applied to the columns followed by 1D compression applied to the rows. The first values required for the decompression are fond in header2.

For 3D fields, the methods are the same except that the formula given in the Appendix is used to reconstruct the values from the differences.

**Improvements and Advantages Obtained Compared to the State of the Art**

We claim that

1) the invention yields better compression factors at faster execution speeds than any other lossless compression method for GRIB files know today.
2) The method is at least as fast as any lossless compression method for GRIB files know today.
3) The files compressed on one computer can be decompressed without loss on any other computer: the method is computer independent.

This is achieved with a combination of preprocessing using differences and a 2D lossless graphic compression method (JPEG-LS for example).

1) By using differences as preprocessing, both the smoothness of the data as well as the 3D correlation of the data is exploited for high compression factors to the fullest degree. For this reason, the compression factors are higher for GRIB data than by any other lossless compression method.
2) The additional computational effort due to preprocessing by taking differences is negligible. Thus the computational effort is effectively only due to the lossless 2D method used. We have chosen JPEG-LS because it is the fastest and has compression ratios which are only marginally less than the best lossless 2D compression method (CALIC).
3) Both components use integer arithmetic. Thus the method is computer independent

**An Example**

As an example, we compress a suite of GRIB files which was generated in a weather forecast for Northern and Central Europe (local model Europe, LME) by the German Weather Service. This suite consists of 368 GRIB files with a total size of 321 MB. It includes five variables which were processed as 3D fields (with 40 layers each). Two other variables could also have been compressed as 3D fields, but it turned out to be more favorable to compress each of the layers as 2D fields.

The GRIB encoding uses 16 bits for each of the values. The results presented were calculated on a 2.3 GHZ Linux PC.

| File | LM-E (320MB) |
|---|---|
| Compression factor | 3,17 |
| Calculation time (for either compression or decompression) | 20 sec. |
| Throughput | 16 MB/sec. |

Thus the total size of 321 MB was losslessly compressed to about 100 MB.

## Detailed Description

In the following, the method will be described in more detail.

For a 2D field of integers $F_{i,j}$, i = 1,..., N, j = 1,..., M second order differences $G_{i,j}$ are given by

$$G_{1,1} = F_{1,1}$$

$$G_{1,j} = F_{1,j} - F_{1,j-1} \quad \text{for } j = 2,..., N$$

$$G_{i,1} = F_{i,1} - F_{i-1,1} \quad \text{for } i = 2,..., M$$

$$G_{i,j} = F_{i,j} - F_{i-1,j} - F_{i,j-1} + F_{i-1,j-1} \quad \text{for } i = 2,..., M, \text{ for } j = 2,..., N$$

2D differences as well as 3D differences have three properties

a) The new field of values $G_{i,j}$ is as large (i.e., contains as many values) as the original field $F_{i,j}$.
b) $F_{i,j}$ can be reconstructed from $G_{i,j}$.
c) If $F_{i,j}$ consists of the values of a smooth variable, then the numbers $G_{i,j}$ are smaller than the $F_{i,j}$ and can be better compressed.

The preprocessing depends on whether 2D differences or 3D differences are taken.

## Taking 2D Differences of 2D Data

It is assumed that the 2D field of integers $F_{i,j}$ has been extracted from the GRIB file. The GRIB encoding also involves three other values which will not be used here and one which is sometimes used. They are the binary and decimal scaling factors and the reference value. The bit length $B$ is sometimes used.

2D differences can be applied either not at all, once or twice. This choice has already been explained.

0) If 2D differences are not used at all, the 2D field together with the bit length is passed to JPEG-LS for compression.
1) If 2D differences are applied once, one obtains the field of differences $G_{i,j}$, as described above. The first value $G_{1,1}$ is stored separately and its value in the field $G_{i,j}$ is set to 0. Let us call this new field $G_{i,j}^{1}$. The smallest number $G_{min}^{1}$ in this field is determined and is subtracted from all the numbers in the field. The result is the field $H_{i,j}$, a field of nonnegative integers. Then the "bit length of the field" is determined. This is the bit length necessary to store the largest number in the field. Finaly, this bit length and the field $H_{i,j}$ are passed to JPEG-LS for compression.
2) If 2D differences are to be applied twice, then one first proceeds as in 1) until one has obtained the field $H_{i,j}$. 2D differences are taken of this field to obtain the field $K_{i,j}$.
The first row $K_{1,j}$, j =1,...,N and the first column $K_{i,1}$, i = 2,..., M of this field are stored separately and these values are replaced by zeros in $K_{i,j}$. The result is the field $K_{i,j}^1$. Then one continues as in 1). That is, $K_{\min}^1$, a field of nonnegative values and its bit length are determined and passed to JPEG-LS for compression.

**The GRIB Format**

The compression of 3D fields requires detailed knowledge of the GRIB format. The GRIB format is applied to 2D fields $X_{i,j}$ of floating point numbers. The process includes scaling the numbers according to the needs of the user. First each number is multiplied by a power $D$ of 10, namely $10^D$. This decimal scaling factor is a positive or negative integer. Then the reference value, $R$, is determined. It is the smallest number in the field (after the decimal scaling) and is stored as a single precision floating point number. $R$ is subtracted from all the numbers in the field to obtain a field of nonnegative floating point numbers. This field is multiplied by $2^{-E}$. This is the binary scaling and the binary scaling factor $E$ is a positive or negative integer. Finally, the integer part of this field is taken to obtain $F_{i,j}$ which are the binary numbers stored in the GRIB file. The bit length of this field is determined and stored in the header. The formula

$$10^D X = R + F 2^E$$

gives the connection between the original floating point number $X$ and its formatted equivalent. The decimal and binomial scaling factors $D$ and $E$ as well as the reference value $R$ are stored in the header of the GRIB file.

The GRIB format allows one to format the values of a 3D field belonging to different layers with different precisions. This is what causes difficulties for 3D wavelet methods, since they depend on the fact that all values occurring have the same precision. As a result, the compression factors are worse.

**Application of 3D Differences to 3D Data**

It is assumed that the binary GRIB data belonging to a 3D field has been extracted to $F_{i,j,k}$ i =1,..., M, j = 1,..., N, k =1,..., R. In addition, we will use the decimal $D_k$ and binary $E_k$ scaling factors associated to the 2D fields k =1,..., R. 3D differences are either not taken or taken once. How this is decided has already been explained.

1) If 3D differences are not to be taken, then the 2D layers are just compressed separately as explained in the last section.

2) If 3D differences are to be taken, then first 2D differences are taken at each level. Note that each level contains the data coming from one GRIB file. The result is the field $G_{i,j,k}$, which we consider as a sequence of 2D layers $(G_{i,j})_k$ together with the unchanged scaling factors $D_k$ and $E_k$. We will now take 1D in the third dimension (height) in the following way, to obtain a new 3D field $(H_{i,j})_k$.

A) $(H_{i,j})_1 = (G_{i,j})_1$ for i = 1,..., M, j =1,..., N

B) First let

$$D = \max (D_k, D_{k-1}) \quad \text{and} \quad E = \min (E_k, E_{k-1})$$

Then

$$(H_{i,j})_k = 10^{-D_k+D} 2^{E_k-E} (G_{i,j})_k - 10^{-D_{k-1}+D} 2^{E_{k-1}-E} (G_{i,j})_{k-1} \quad \text{for} \quad k = 2,...,R$$

Since the powers appearing in this formula are all positive, the values in $(H_{i,j})_k$ are all integers. The first row $(H_{i,j})_1$ and the first column $(H_{i,j})_1$ of the first layer $(H_{i,j})_1$ are stored separately and their values in the field are replaced by zeros. Then one proceeds as at the end of 2) for 2D differences. Now each of the other layers are processed as in 1) for 2D fields after differences have been taken. The result is for each k =1,..., R a field minimum $H_{\min}^k$, a bit length

$B_k$ and a field of nonnegative integers $(H_{i,j})_k$ which are passed to JPEG-LS for compression.

**The Complete Method**

The compressed file consists of two headers and the compressed data. The first header, header1, is

    1) for 2D data: the GRIB header
    2) for 3D data: the concatenation of the GRIB headers of the data included in the 3D field.

These headers are copied directly from the GRIB files and not compressed.

Header2 contains the auxiliary information necessary to decompress the data. It contains the data that was stored separately from the compressed fields and the field minima. The bit lengths are not stored. Header2 also contains additional book keeping details which will not be explained here. For example, one must know where Header2 ends and where the data compressed by JPEG-LS starts.

The difference between manual and automatic determination of the number of differences to be taken is only that in the automatic mode, differences are taken until a termination criterion is met, while in the manual mode the number of differences to be taken is fixed for each variable once and for all. Therefore only the manual mode is described.

    1) The method for 2D data: the GRIB header is written as header1. Then 0), 1) and 2) as described above for 2D data are carried out in dependence of the number of differences to be taken. For 0), the compressed data are written to the compressed file. For 1), the first value $F_{1,1}$ and the minimum value of the field of the field obtained after taking differences are written to header2. Then the compressed data is written to the file. For 2), the first row and the first column $K_{i,j}$ and the minimum value of the field of the field obtained after taking differences twice are written to header2. Then the compressed data is written to the file.

    2) The method for 3D data: All GRIB headers are written to header1. Then 1) and 2) as described above for 3D data are carried out in dependence of the number of differences to be taken. For 1), the data is compressed by JPEG-LS and then written to the file. For 2), the first row and the first column of the lowest layer $(H_{i,j})_1$ are written to header2. The first values $(H_{1,1})_k$, for k = 2,..., R of the other layers $(H_{1,1})_k$ as well as all the field minima are the written to header2 and then all of the compressed 2D fields are written one after the other to the compressed file.

**The Decompression**

The first step of the decompression is just applying JPEG-LS decompression to all of the 2D fields involved. Then the minimum values of all of the 2D fields are added back. These minimum values are in header2.

The principle of the decompression of the differences can be explained most easily in the one dimensional case. Then the uncompressed data is a sequence of positive integers $F_i$ for $i$ =1,...,M. The differences for this field are $G_i = F_i$ - $F_{i\text{-}1}$ for i = 2,...,M. For the decompression, these differences as well as the first value $F_1$ of the field are available.

From $F_1$ and $G_2 = F_2$ - $F_1$, we obtain $F_2$. From $F_2$ and $G_3 = F_3$ - $F_2$, we obtain $F_3$ and so on.

2D differences are formed by first applying 1D differences to the rows, then 1D differences to the columns. 2D decompression is then 1D decompression applied to the columns followed by 1D compression applied to the rows. The first values required for the decompression are fond in header2.

For 3D fields, the methods are the same except the formula 2)B) must be inverted. For the decompression we have $(G_{i,j})_{k\text{-}1}$ and $(H_{i,j})_k$ given and we want to calculate $(G_{i,k})_k$. First we can calculate $D$ and $E$ from the original scaling factors stored in header1. The formula for $(G_{i,j})_k$ is then

$$(G_{i,j})_k = 10^{D_k-D} 2^{E_k+E} \{(H_{i,j})_k + 10^{-D_{k-1}+D} 2^{E_{k-1}+E} (G_{i,k})_{k-1}\}$$

Note that first the value in the curly brackets is to be calculated and afterwards multiplied by its factor. This is necessary to stay within the bounds of integer arithmetic.

**Further Examples showing the Interplay of 3D Differences and Scaling Factors**

We give three examples. In the first example, we take adjacent layers of a 3D data set for which the binomial scaling factor differs by one. The decimal scaling factors are the same. In the second example, the decimal scaling factors differ by one, while the binomial scaling factors are the same. In the third example, we take differences of the lowest and highest levels to demonstrate why one cannot exploit 3D correlation over many layers.

Remember, that we are hoping to obtain smaller numbers by taking differences since they can be compressed better.

### Example 1

This example comes from data of the German Weather Service. The quantity measured is specific humidity on a 325 X 325 grid with 35 layers. We consider values on the 17-th and 18-th layers in the middle of the field. We label the grid positions by (i, j). The values stored in the GRIB file are

| Layer=17 | |
|---|---|
| (i, j) | value |
| (161, 161) | 3363 |
| (161, 162) | 3271 |
| (162, 161) | 3619 |
| (162, 162) | 3612 |

| Layer = 18 | |
|---|---|
| (i, j) | value |
| (161, 161) | 2247 |
| (161, 162) | 2139 |
| (162, 161) | 2295 |
| (162, 162) | 2242 |

The decimal scaling factors are both 0. The binomial scaling factors are $E_{17}$ = -23 and $E_{18}$ = -22. The reference value for layer 17 is $R$ = 1.73294*10$^{-5}$ so that, for example, the value of the specific humidity at the grid point (161, 161) of layer 17 is 1.73294*10$^{-5}$ + 2247*2$^{-23}$. Taking 2D differences in layer 18, we obtain $(G_{162,162})_{18}$ = 2242 - 2295 -2139 + 2247 = 55. Taking 2D differences in layer 17, we obtain $(G_{162,162})_{17}$ = 3612 - 3619 - 3271- 3363 = 85. To apply the formula for 3D differences, we need $D$ = max($D_{17}$,$D_{18}$) = max(0,0) = 0 and $E$ = min($E_{17}$,$E_{18}$) = min(-23,-22) = -23.

Then

$$(H_{162,162})_{18} = 10^{-0+0}2^{-22-(-23)} * 55 - 10^{-0+0}2^{-23-(-23)} * 85 = 110 - 85 = 25$$

The binary form of 25 is 11001 which is 5 bits large instead of the original 16 bits.

### Example 2

This example is taken from a GRIB file of the NOAA (National Oceanic and Atmospheric Organization). The quantity measured is also specific humidity but in kg/kg (the units in Example 1 are kg/m^3). The grid size is 147 X 110.

| Layer = 28 | |
|---|---|
| (i, j) | value |
| (54, 73) | 159 |
| (54, 74) | 140 |

(continued)

| Layer = 28 | |
|---|---|
| (i, j) | value |
| (55, 73) | 137 |
| (55, 74) | 109 |

| Layer = 29 | |
|---|---|
| (i, j) | value |
| (54, 73) | 15 |
| (54, 74) | 15 |
| (55, 73) | 16 |
| (55, 74) | 14 |

The decimal scaling factors are $D_{28} = 4$ and $D_{29} = 3$, while the binomial scaling factors are both-2 and will not be needed to compute the 3D differences. The bit length for layer 28 is 9 while the bit length for layer 29 is 6. We obtain $(G_{55,74})_{28} = 159$ -140 -137 + 109 = -9 and $(G_{55,74})_{29} = 15$ -15 -16 + 14 = -2. We also need $D = \max(D_{28}, D_{29}) = \max(4,3) = 4$.
Then

$$(H_{55,74})_{29} = 10^{-3+4} * (-2) - 10^{-3+3} * (-9) = 10 * (-2) - (-9) = -11$$

The binomial form of -11 is -1011 which is 4 (5) bits.

**Example 3**

This example demonstrates what happens if 3D differences are taken on two layers which are as far apart as possible. It demonstrates the difficulties the GRIB format causes for 3D compression, in particular for 3D wavelet methods. The data set is the same as in Example 1 except that now we take layers 1 and 35. The values in the GRIB files are

| Layer = 1 | |
|---|---|
| (i, j) | value |
| (161, 161) | 9071 |
| (161, 162) | 8980 |
| (162, 161) | 8877 |
| (162, 162) | 8804 |

| Layer = 35 | |
|---|---|
| (i, j) | value |
| (161, 161) | 7890 |
| (161, 162) | 7617 |
| (162, 161) | 7876 |
| (162, 162) | 7684 |

**13**

The decimal scaling factors are both 0 and will not be needed. The binomial scaling factors are $E_1 =$ -21 and $E_{35} =$ -34. We have $E = \min(E_1, E_{35}) = \min(-21, -34)=$ -34. Also $(G_{162,162})_1 = 8804 - 8980 - 8877 + 8804 =18$ while $(G_{162,162})_{35} = 7684 - 7876 - 7617 + 7890 = 81$. Thus

$$(H_{162,162})^*_{35} = 2^{-34-(-34)} * 81 - 2^{-21-(-34)} * 18 = 81 - 18 * 2^{13}$$

Writing this number in binary form

$$(H_{162,162})^*_{35} = -100.01111.11101.01111$$

The decimal points are included just to make it easier to count the number of bits which is 18. The original number of bits was 16. Thus, instead of getting smaller numbers, we obtain larger ones.

**Summary of the Explanation of Lossless Compression of GRIB1 Files**

1) Starting point: A GRIB file which contains 2D grids of floating point numbers formatted in a particular way. The main content is a 2D field of integers numbers. In order to extract the floating point numbers they represent, two scaling factors, decimal and binomial, as well as a reference value are used. In addition, there is a header which describes the data contained in the file.
2) If a single GRIB file is to be compressed (called 2D compression), only the 2D field of integers is used.
3) The other possibility is "3D compression", which involves a new method for using 3D correlation of GRIB data for compression. It is used when one has a sequence of GRIB files containing the values of some quantity on grids at different heights above the surface of the earth. In this case all of these files are compressed together. Then the 2D fields of integers as well as the scaling factors are used.
4) The main components of the method are

a) 2D or 3D differences as preprocessing. These are extremely fast and invertible methods, i.e., the original data can be recovered from the data obtained by differencing.
b) A 2D lossless compression method for integer fields which uses integer arithmetic. We have chosen JPEG-LS, but any other such method would work also. The choice is a question of how fast the method is and how well it compresses.

5) The 2D case: 2D differences are applied to the field of integers a certain number of times (including not at all). The result is then compressed by JPEG-LS.
6) The 3D case: in this case, the numbers contained in different integer fields may not be comparable. For this reason, scaling factors are used in forming 3D differences to make them comparable.

a) First 2D differences are first applied to each of the 2D fields a certain number of times.
b) Then 1D differences are applied in the third dimension (height), that is between neighboring 2D fields, using a special formula incorporating the scaling factors.
c) Then each of the resulting 2D fields is compressed separately by JPEG-LS.

7) In each of the cases, 2D and 3D, the compressed fields of integers as well as the (uncompressed) headers of the original GRIB files are collected into one file, which is the compressed file.
8) The decompression just runs backwards, since each of the data transformations is exactly invertible.

**A More General Application**

The method described above, could also be applied to either 2D or 3D scaled fields of floating point numbers. A 2D field of floating point numbers is called scaled if it is represented as a 2D field of integers all having the same scaling factors. More exactly, it is a field of numbers $X_{i,j}$ of the form

$$X_{i,j} = N_1^{-D_1}\{R + F_{i,j}N_2^{D_2}\}$$

Here $N_1$ and $N_2$ are nonnegative integers, $D_1$ and $D_2$ are integers, $F_{i,j}$ is a field of integers and $R$ is a real number, either a floating point number or an integer.

One example of this is the GRIB format in which $N_1$ =10, $N_2$ = 2 and $R$ is a single precision floating point number. But any field of floating point numbers can be put into this form. In general, a field of computer floating numbers $X_{i,j}$ has the form $X_{i,j} = 2^{E_{i,j}} F_{i,j}$, where $F_{i,j}$ is the mantissa (an integer) and $E_{i,j}$ is the exponent. Let $E$ = min $\{E_{i,j}\}$. Then

$$X_{i,j} = 2^E \{2^{E_{i,j}-E} F_{i,j}\} = 2^E G_{i,j}$$

where $G_{i,j}$ is a field of integers. For the purpose of compression, it is favorable that the integers involved are as small as possible. Thus let $G$ = min $G_{i,j}$. Then

$$X_{i,j} = 2^E \{G_{i,j} - G\} + 2^E G = 2^E H_{i,j} + R$$

This is of the form given above with $N_1$ =1 and $N_2$ = 2.

One application is the compression of 3D fields of floating point numbers. Such a field can be sliced into horizontal 2D fields. Each 2D field is represented as just explained, with its own scaling factor and own "reference" number $R$ . Then exactly the same method as for GRIB files can be applied. This will yield better compression factors than 3D methods if the 2D fields contain numbers of sizes differing from those in the other fields. This is the typical behavior of meteorological fields for which low levels contain large numbers and high lying fields contain small numbers.

**Claims**

1.  Method for data compression performing preprocessing of several data layers of two-dimensional integer data $(F_{i,k})_k$, each layer $k$ having its individual integer scaling factors $D_k$ and $E_k$, said $R$ data layers of two-dimensional integer data representing three-dimensional floating point data $(X_{i,j})_k$, in particular three-dimensional meteorologic data, wherelit $(X_{i,j})_k$ is represented by

$$N_1^{-D_k} \left\{R_k + \left(F_{i,j}\right)_k N_2^{E_k}\right\}$$

wherein $N_1$ = 10 and $N_2$ =2 are nonnegative integer $D_k$ and $E_k$ are integers and $R_k$ are real numbers, either floating point or integer, wherein the method comprises the steps of

    a. determining differences between respective adjacent data within each of the two-dimensional integer data layers $(F_{i,j})_k$ so as to obtain two-dimensional differential data layers $(G_{i,j})_k$ comprising differential data, and
    b. determining differences between the differential data of respective adjacent two-dimensional differential data layers $(G_{i,j})_k$ so as to obtain a three-dimensional field of differential data $(H_{i,j})_k$, wherein the factors of the linear combination are derived from the scaling factors associated to the respective two-dimensional integer data layers, wherein the differences are determined as follows:

$$\tilde{D}_k = \max(D_k, D_{k-1}) \text{ and } \tilde{E}_k = \min(E_k, E_{k-1})$$

$$\left(H_{i,j}\right)_k = N_1^{-D_k+\tilde{D}_k} N_2^{E_k-\tilde{E}_k} (G_{i,j})_k - N_1^{-D_{k-1}+\tilde{D}_k} N_2^{E_{k-1}-\tilde{E}_k} (G_{i,j})_{k-1} \text{ for } k = 2,...,R$$

$$\left(H_{i,j}\right)_1 = (G_{i,j})_1$$

**2.** Method according to claim 1, further comprising the step of c. compressing each layer of the three-dimensional field of differential data $(H_{i,j})_k$ obtained in step (b) using a two-dimensional data compression such as e.g. JPEG LS or JPEG 2000.

## Patentansprüche

**1.** Verfahren zur Datenkompression unter Vorverarbeitung mehrerer Datenschichten zweidimensionaler Ganzzahl-Daten $(F_{i,j})_k$, wobei jede Schicht $k$ ihre individuellen Ganzzahl-Skalierungsfaktoren $D_k$ und $E_k$ aufweist, wobei die aus zweidimensionalen Ganzzahl-Daten bestehenden R Datenschichten dreidimensionale Fließkommadaten $(X_{i,j})_k$, insbesondere dreidimensionale metereologische Daten, darstellen, wobei $(X_{i,j})_k$ wiedergegeben wird durch

$$N_1^{-D_k} \{ R_k + (F_{i,j})_k N_2^{E_k} \}$$

wobei $N_1 = 10$ und $N_2 = 2$ nichtnegative Ganzzahlen sind, $D_k$ und $E_k$ Ganzzahlen sind, und $R_k$ reelle Zahlen, entweder in Form von Fließkommazahlen oder von Ganzzahlen, sind, wobei das Verfahren die folgenden Schritte aufweist:

   a. Bestimmen der Differenzen zwischen jeweiligen benachbarten Daten innerhalb jeder der beiden zweidimensionalen Ganzzahl-Datenschichten $(F_{i,j})_k$, um zweidimensionale differentielle Datenschichten $(G_{i,j})_k$ zu erhalten, welche differentielle Daten enthalten, und
   b. Bestimmen der Differenzen zwischen den differentiellen Daten jeweiliger benachbarter zweidimensionaler differentieller Datenschichten $(G_{i,j})_k$, um ein dreidimensionales Feld differentieller Daten $(H_{i,j})_k$ zu erhalten, wobei die Faktoren der linearen Kombination von den Skalierungsfaktoren abgeleitet werden, welche den jeweiligen zweidimensionalen Ganzzahl-Datenschichten zugeordnet sind, wobei die Differenzen wie folgt bestimmt werden:

$$\widetilde{D}_k = \max(D_k, D_{k-1}) \; und \; \tilde{E}_k = \min(E_k, E_{k-1})$$

$$(H_{i,j})_k = N_1^{-D_k+\widetilde{D}_k} N_2^{E_k-\bar{E}_k} (G_{i,j})_k - N_1^{-D_{k-1}+\widetilde{D}_k} N_2^{E_{k-1}-\bar{E}_k} (G_{i,j})_{k-1} \; f\ddot{u}r \; k = 2, \dots, R$$

$$(H_{i,j})_1 = (G_{i,j})_1$$

**2.** Verfahren nach Anspruch 1, ferner mit dem Schritt

   c. des Komprimierens jeder Schicht des in Schritt (b) erhaltenen dreidimensionalen Feldes differentieller Daten $(H_{i,j})_k$ unter Verwendung zweidimensionaler Datenkompression wie beispielsweise JPEG LS oder JPEG 2000.

## Revendications

**1.** Procédé de compression de données, exécutant le pré-traitement de plusieurs couches de données entières bidimensionnelles $(F_{i,j})_k$, chaque couche $k$ ayant ses facteurs d'échelle entiers individuels $D_k$ et $E_k$, lesdites couches de données $R$ de données entières bidimensionnelles représentant des données à virgule flottante tridimensionnelles $(X_{i,j})_k$, en particulier des données météorologiques tridimensionnelles, $(X_{i,j})_k$ étant représenté par

$$N_1^{-D_k} \{ R_k + (F_{i,j})_k \, N_2^{E_k} \}$$

oú $N_1 = 10$ et $N_2 = 2$ sont des entiers non-négatifs, $D_k$ et $E_k$ sont des entiers et $R_k$ sont des nombres réels, soit à virgule flottante, soit entiers, le procédé comprenant les étapes suivantes:

   a. déterminer des différences entre des données adjacentes respectives à l'intérieur de chacune des couches de données entières bidimensionnelles $(F_{i,j})_k$ de façon à obtenir des couches de données différentielles bidimensionnelles $(G_{i,j})_k$ comprenant des données différentielles, et
   b. déterminer des différences entre les données différentielles de couches de données différentielles bidimensionnelles adjacentes respectives $(G_{i,j})_k$, de façon à obtenir un champ tridimensionnel de données différentielles $(H_{i,j})_k$, les facteurs de la combinaison linéaire étant dérivés des facteurs d'échelle associés aux couches de données entières bidimensionnelles respectives, les différences étant déterminées comme suit:

$$\widetilde{D}_k = \max(D_k, D_{k-1}) \; et \; \tilde{E}_k = \min(E_k, E_{k-1})$$

$$(H_{i,j})_k = N_1^{-D_k + \widetilde{D}_k} \, N_2^{E_k - \tilde{E}_k} \, (G_{i,j})_k - N_1^{-D_{k-1} + \widetilde{D}_k} \, N_2^{E_{k-1} - \tilde{E}_k} \, (G_{i,j})_{k-1} \; pour \; k = 2, \dots, R$$

$$(H_{i,j})_1 = (G_{i,j})_1$$

2. Procédé selon la revendication 1, comprenant, en outre, l'étape consistant à:

   c. compresser chaque couche du champ tridimensionnel de données différentielles $(H_{i,j})_k$ obtenu à l'étape (b) au moyen d'une compression de données bidimensionnelles telle que, par ex., JPEG LS ou JPEG 2000.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- FM 92-IX Ext. - GRIB. World Meteorological Organization (WMO) Manual on Codes. 1988, vol. 1
- **AIAZZI B et al.** Reversible compression of multispectral imagery based on an enhanced inter-band JPEG prediction. *GEOSCIENCE AND REMOTE SENSING,* 1997, vol. 4 (3), 1990-1992
- **JUNGWOO LEE.** Least squares approach for predictive coding of 3-D images. *PROCEEDINGS OF THE INTERNATIONAL CONFERENCE ON IMAGE PROCESSING,* vol. 1, 875-878